(19) Europäisches Patentamt
European Patent Office
Office européen des brevets

(11) **EP 2 682 762 A1**

(12) **EUROPEAN PATENT APPLICATION**

(43) Date of publication:
**08.01.2014 Bulletin 2014/02**

(51) Int Cl.:
***G01R 15/20*** (2006.01)

(21) Application number: **12175456.8**

(22) Date of filing: **06.07.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Senis AG**
**6300 Zug (CH)**

(72) Inventors:
• **Popovic, Radivoje**
**6300 Zug (CH)**

• **Walker, Ian James**
**Woodside, CA 94062 (US)**
• **Dimitrijevic, Sasa**
**18251 Mramor, Nis (RS)**
• **Blagojevic, Marjan**
**18000 Nis (RS)**
• **Law, Karren Louis**
**Cheney, WA 99004 (US)**

(74) Representative: **Falk, Urs**
**Patentanwaltsbüro Dr. Urs Falk**
**Eichholzweg 9A**
**6312 Steinhausen (CH)**

(54) **Current transducer for measuring an electrical current, magnetic transducer and current leakage detection system and method**

(57) The invention concerns a current transducer for measuring a current flowing through a cable, comprising at least one magnetic field sensor and an electronic circuit. The current transducer comprises a head (40) with a ferromagnetic core (46) optimized to reduce the effects of external magnetic fields. The invention further concerns a magnetic transducer comprising a magnetic field sensor and an electronic circuit. The electronic circuit comprises at least one current source (2), a transformer (3), a fully differential preamplifier (4) coupled to the transformer (3), a phase sensitive detector (6) coupled to the preamplifier (4) and a logic block (5, 5a) configured to operate the magnetic field sensor(s) to provide an AC output voltage. The magnetic field sensor(s) is either a Hall element (1) or an AMR sensor (19). The invention further concerns a current leakage detection system having such magnetic transducers.

Fig. 21

EP 2 682 762 A1

**Description**

FIELD OF THE INVENTION

The invention relates to a current transducer for measuring an electrical current flowing through a cable, a magnetic transducer and a current leakage detection system and method.

BACKGROUND OF THE INVENTION

One important application of magnetic transducers is non-invasive current measurement (without breaking the cable carrying a current) by measuring the magnetic field produced by the current. A convenient way to perform such current measurement is by using a current transducer, including a so-called clamp-on current transducer. A current transducer capable of measuring DC and AC currents usually consists of a combination of a ferro-magnetic core, which encloses a current-carrying cable, and a magnetic transducer. The lowest value of the current that can be measured via the associated magnetic field critically depends on the intrinsic noise of the magnetic transducer and on the sensitivity of the measurement system to external magnetic fields. The accuracy of a clamp-on ammeter is also limited by the dependence of the measurement result on the position of the enclosed cable with respect to the symmetry axis of the ferromagnetic core.

Big electrical machines of all kinds and for different purposes, like for example electricity generators, may develop during manufacture or in the course of time a current leakage path which may result in the worst case in a short circuit. There is a high risk that the machine is damaged if a short circuit occurs. To decrease the risk, big electrical machines are periodically tested in order to detect, and, if detected, to localize a current leakage path. For such tests very sensitive and very disturbance-immune clamp-on ammeters are needed.

DISCLOSURE OF THE INVENTION

The object of the invention is to develop a magnetic transducer with the following characteristics:

- very high DC and low-frequency AC magnetic resolution - down to or below 1nT;
- capable of measuring either a magnetic field at a certain location, or a difference of magnetic fields at two locations;
- very small dimensions of the magnetic-field-sensitive part of the transducer (which is further referred to as magnetic sensor) - down to or below 1 mm (so that the sensor can be fitted into or near an air gap of a ferromagnetic core, the gap being of the order of 1 mm).

Another object of the invention is to develop an electrical current transducer

- capable of measuring very low electrical DC and AC currents, down to 100 $\mu$A or even down to the order of 1 $\mu$A,
- with high immunity to disturbing magnetic fields, particularly those produced by other current-carrying cables,
- and with low sensitivity to the position of the enclosed current-carrying cable.

Still another object of the invention is to develop a system and method for detecting and locating a current leakage path of high electrical resistance in an electrical machine. High electrical resistance means a resistance in the order of magnitude of 100 M$\Omega$. The system should therefore be capable of measuring electrical DC currents down to 100 $\mu$A or even down to the order of 1 $\mu$A.

SHORT DESCRIPTION OF THE INVENTION

The objects of the invention are solved by current transducers as claimed in claims 1, 2 and 4, a magnetic transducer according to claims 8 and 9, a current leakage detection system according to claim 11 and a method to detect a leakage current according to claim 12. Solutions with further advantages are disclosed in the dependent claims.

BRIEF DESCRIPTION OF THE DRAWINGS

The accompanying drawings, which are incorporated into and constitute a part of this specification, illustrate one or more embodiments of the present invention and, together with the detailed description, serve to explain the principles and implementations of the invention. The figures are not to scale. In the drawings:

Fig. 1          shows a first embodiment of a magnetic transducer according to the invention,

Figs. 2, 3      show variants of the first embodiment of the magnetic transducer,

Figs. 4 to 7      shows four phases of a spinning current method,

Fig. 8      shows a diagram illustrating the spinning current method,

Fig. 9      shows a preferred embodiment of a constant current source,

Fig. 10      shows a second embodiment of a magnetic transducer according to the invention,

Fig. 11      shows a circuit capable of producing set and reset current pulses,

Fig. 12      shows a third embodiment of a magnetic transducer according to the invention,

Fig. 13      shows a variant of the third embodiment of the magnetic transducer,

Fig. 14      shows a fourth embodiment of a magnetic transducer according to the invention,

Fig. 15      shows a fifth embodiment of a magnetic transducer according to the invention,

Fig. 16      shows a sixth embodiment of a magnetic transducer according to the invention,

Fig. 17      shows a system for detecting a leakage current in an electrical machine, comprising two current transducers with measurement heads,

Fig. 18      shows a head of the prior art having one ferromagnetic core and one magnetic sensor,

Fig. 19      shows a head of the prior art having one ferromagnetic core and two magnetic sensors,

Figs. 20-23      show schematic views of different embodiments of a head according to the invention having one ferromagnetic core,

Fig. 24      shows a schematic view of a head according to the invention having two ferromagnetic cores,

Figs. 25A, B      show an embodiment of such a head,

Fig. 26      shows a head comprising AMR sensors,

Figs. 27, 28      show details of a head comprising AMR sensors,

Fig. 29      shows the equivalent electrical circuit of an electrical machine and a current leakage detection system coupled to it.

## DETAILED DESCRIPTION OF THE INVENTION

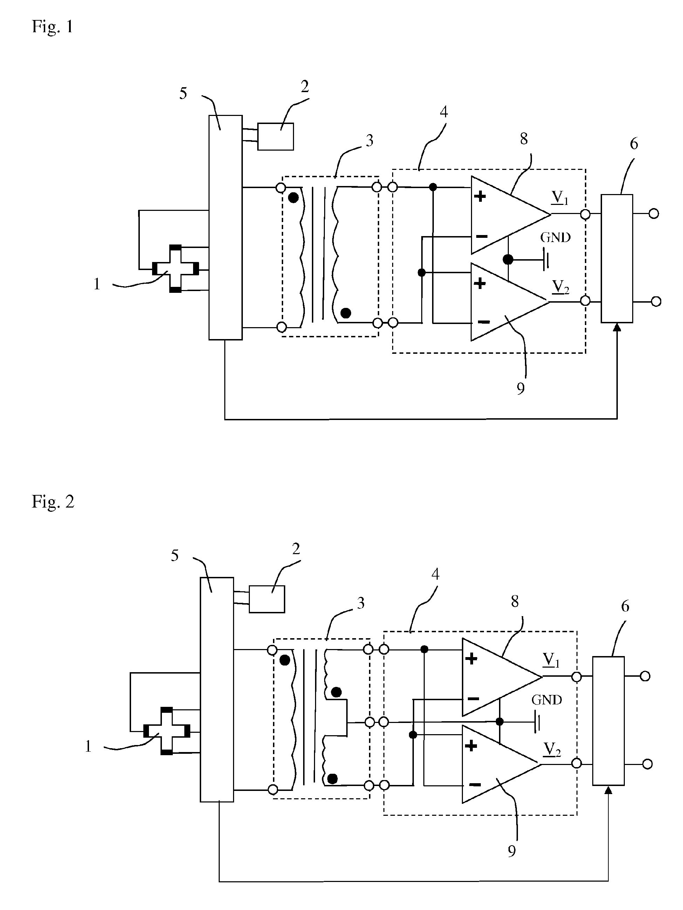

Fig. 1 shows a diagram of a first embodiment of a magnetic transducer according to the invention. The magnetic transducer comprises a magnetic field sensor and electrical circuitry to operate the magnetic field sensor. In this first embodiment, the magnetic field sensor is a Hall element 1. The electrical circuitry comprises a first current source 2 providing a supply current to the Hall element 1, a transformer 3, a preamplifier 4, a logic block 5 and a phase sensitive detector 6. The transformer 3 has a primary winding with two input terminals and a secondary winding with two output terminals. The preamplifier 4 is a fully differential amplifier having two input terminals and two output terminals. The first output terminal of the transformer 3 is coupled to the first input terminal of the preamplifier 4 and the second output terminal of the transformer 3 is coupled to the second input terminal of the preamplifier 4.

A Hall element is a magnetic field sensor having four terminals, namely two terminals for supplying a Hall current flowing through the Hall element and two terminals for tapping a Hall voltage. The term "Hall element" may mean a single Hall element but has to be understood as also to include a group of Hall elements forming a cluster. A cluster of Hall elements has a reduced offset and other advantageous properties. The Hall element my be: a conventional planar Hall element, sensitive to a magnetic field perpendicular to the device surface; or a vertical Hall element, sensitive to a magnetic field parallel with the device surface; or a Hall element (or a cluster of Hall elements) combined with magnetic concentrator(s), which is also sensitive to a magnetic field parallel with the device surface.

The logic block 5 generally serves to operate the magnetic field sensor, in this embodiment the Hall element 1, such as to produce an AC output signal as will be explained further below. The transformer 3 serves to amplify the AC output signal of the magnetic field sensor without adding substantial noise to the signal, and to block sensor offset voltage and low-frequency noise. The voltage gain of the magnetic field sensor's AC output signal, provided by the transformer 3, is equal to the ratio of the numbers of the secondary and primary windings. For example, this ratio could be about 10, but also any other convenient value.

The preamplifier 4 is designed for low noise input current. The preamplifier 4 may be composed of two discrete amplifiers, namely a first amplifier 8 and a second amplifier 9 each having a non-inverting input, an inverting input and an output terminal. The amplifiers 8, 9 are preferably differential amplifiers or instrumentation amplifiers. The non-inverting input of the first amplifier 8 is coupled to the inverting input of the second amplifier 9 and to the first input terminal of the preamplifier 4. The inverting input of the first amplifier 8 is coupled to the non-inverting input of the second amplifier 9 and to the second input terminal of the preamplifier 4. The voltage $V_1$ appearing at the output terminal of the first amplifier 8 and the voltage $V_2$ appearing at the output terminal of the second amplifier 9 are approximately of equal size but opposite sign with respect to ground GND, i.e. $V1 \cong -V_2$. The output terminal of the first amplifier 8 and the output terminal of the second amplifier 9 form the output terminals of the preamplifier 4 and are coupled to input terminals of the phase sensitive detector 6. The phase sensitive detector 6 transforms the difference between the AC voltages $V_1$ and $V_2$ into a DC voltage and provides a DC output signal that is proportional to the magnetic field measured by the magnetic field sensor. The phase sensitive detector 6 generally includes appropriate filters. The transformer 3 is a single component with one core or may be composed of two individual transformers. In addition, the transformer 3 is adequately shielded against external disturbances.

Fig. 2 shows a first variant of the first embodiment where the transformer 3 has a secondary winding with three output terminals, one of the output terminals being a middle terminal. The middle terminal is coupled to ground GND, either directly or as shown to a ground terminal GND of the preamplifier 4.

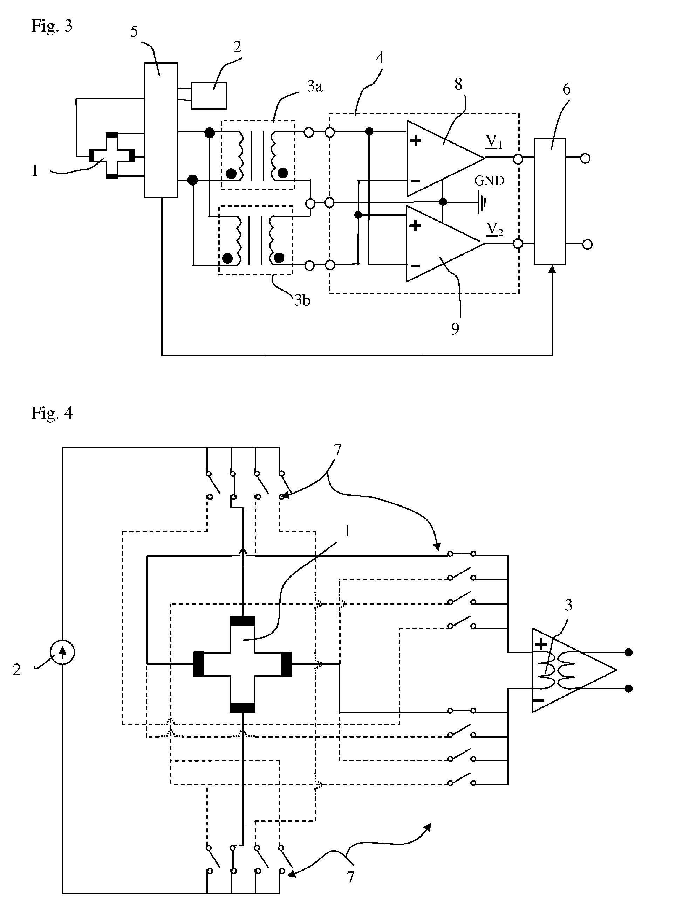

Fig. 3 shows a second variant of the first embodiment where the transformer 3 is composed of two transformers 3a and 3b. The primary windings of the two transformers 3a and 3b are coupled in a parallel manner, the secondary windings are coupled such that two of the four output terminals of the transformers 3a and 3b form a middle terminal. The middle terminal is coupled to ground GND, either directly or as shown to a ground terminal GND of the preamplifier 4.

In all these embodiments the Hall element 1 is operated according to the spinning current method and it is the logic block 5 that serves for this purpose. The spinning current method consists in coupling the Hall element 1 to the current source 2 and the transformer 3 in a cyclic manner running according to a predetermined time clock through four phases, namely phase 1, phase 2, phase 3 and phase 4 (shown in Figs. 4 to 7), or two phases only, namely phase 1 and phase 3. The logic block 5 comprises a clock generator and a plurality of electronic switches 7 for changing between the phases, and control circuitry. The logic block 5 is configured to open and close the electronic switches 7 in order to couple the terminals of the Hall element 1 to the current source 2 and to the input terminals of the transformer 3 according to a predetermined spinning current scheme which is a predetermined coupling sequence run through at a periodical clock derived from the clock generator. The preferred coupling sequence comprises four phases. Figs. 4 to 7 illustrate the state of the switches in the four phases exemplarily for the Hall element 1, the current source 2 and the transformer 3. The polarity of the Hall voltage in phase 1 and in phase 2 is opposite to the polarity of the Hall voltage in phase 3 and phase 4, so that the Hall voltage is supplied to the transformer as AC voltage. The spinning current method serves to separate the Hall voltage from the offset voltage. Any coupling scheme of the four phases is possible as long as it delivers the Hall voltage as an AC voltage and the offset voltage of the Hall element 1 as a DC voltage to the input terminals of the transformer 3. As the transformer 3 does not allow a DC voltage to pass through, the offset voltage of the Hall element 1 is eliminated. The logic block 5 is coupled to the phase sensitive detector 6 and sends the timing or clock signal derived from the clock generator to the phase sensitive detector 6.

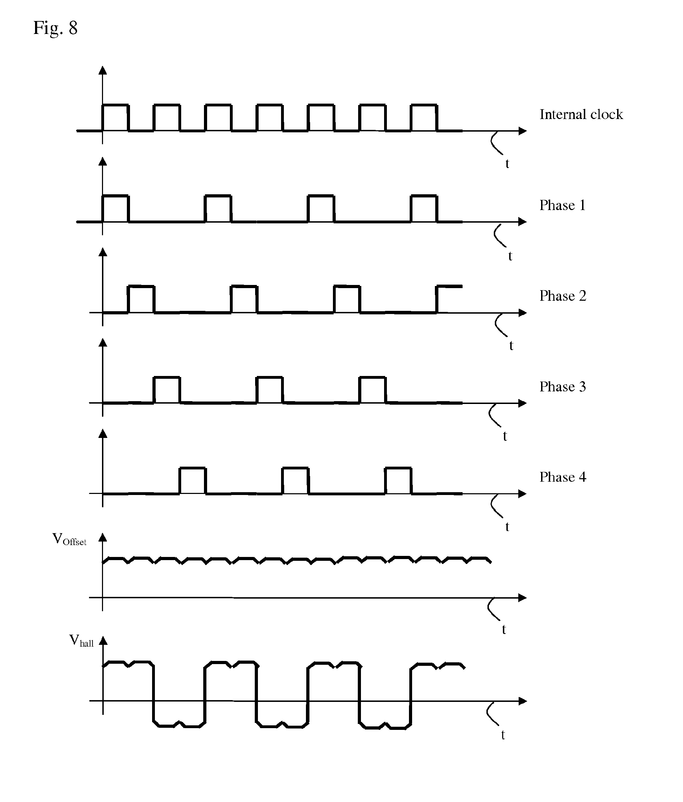

Fig. 8 illustrates the working of the spinning current method for the Hall element 1. From top to down the diagrams show:

- the internal clock signal (derived from the clock generator 27) which initiates the changes of the state of the switches 7 (Figs. 4 to 7) of the logic block 5 (Fig. 1),
- the time when the four phases are active (or with other words when each phase is the active one), and
- the last two diagrams show the DC component of the output signal of the Hall element which is called offset voltage $V_{offset}$ and the AC component of the output signal of the Hall element which is called Hall voltage $V_{hall}$.

The sequence of the four phases is chosen in this case such that a minimum of switches must change their state at the transition from one phase to the next which results in that the frequency of the Hall voltage $V_{hall}$ is half the frequency of the clock signal.

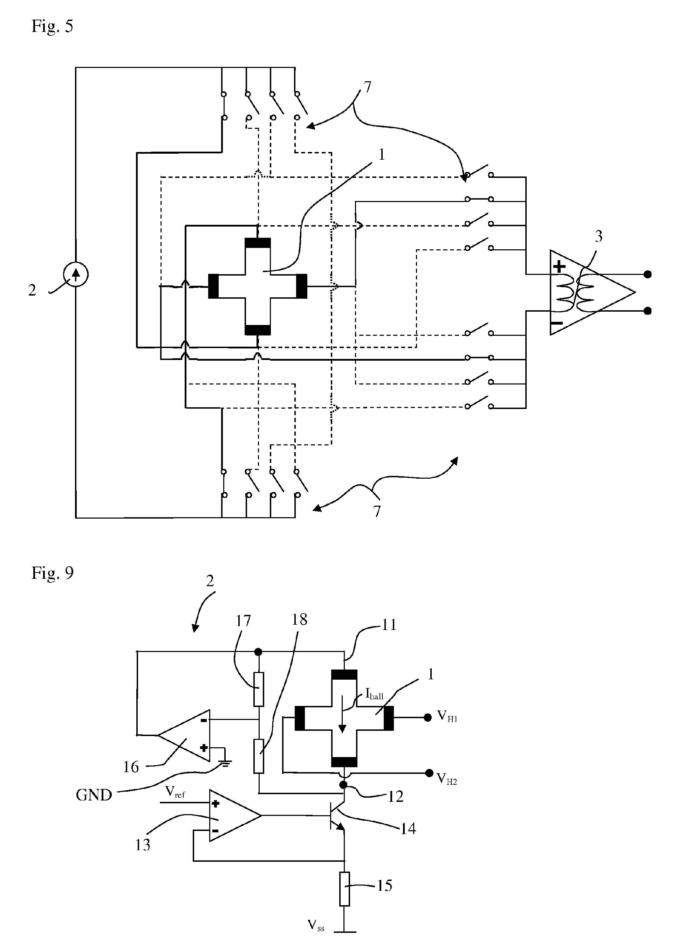

Fig. 9 shows a preferred embodiment of the current source 2 (and current source 29) which works as a constant current source. A Hall element 10 directly coupled to the terminals 11 and 12 of the current source 2 is also shown in order to understand the working way of the current source 2. The current source 2 is composed of a first sub-circuit comprising a first operational amplifier 13, a transistor 14 and a resistor 15, and a second sub-circuit comprising a second operational amplifier 16 and two resistors 17 and 18. The transistor 14 and the resistor 15 are coupled in series and the inverting input of the operational amplifier 13 is coupled to the junction between the transistor 14 and the resistor 15. A reference voltage $V_{ref}$ is applied to the non-inverting input of the operational amplifier 13. This first sub-circuit forms a circuit that can be called a "conventional type" constant current source and it may be replaced by any other type of conventional constant current source. The current source 2 of the present invention as realized with this preferred embodiment also comprises the second sub-circuit. The resistors 17 and 18 are coupled in series. A first terminal of the resistor 17 forms the first terminal of the current source 2, a first terminal of the resistor 18 is coupled to the transistor 14 and forms the second terminal of the current source 2. The second terminals of the resistors 17 and 18 are coupled with each other and coupled to the inverting input of the operational amplifier 16. The non-inverting input of the operational amplifier 16 is coupled to ground GND. The output of the operational amplifier 16 is coupled to the first terminal of the resistor 17. The second sub-circuit makes that the voltage $V_{H1}$ appearing at the first Hall voltage terminal and the voltage $V_{H2}$ appearing at the second Hall voltage terminal of the Hall element 10 as referenced to ground GND are about equal in size but have opposite signs. So if the Hall voltage is designated as $V_H$ then we have with good approximation $V_{H1} = \frac{1}{2} V_H$ and $V_{H2} = -\frac{1}{2} V_H$. Thus, the second sub-circuit of the constant current source 2 biases the Hall element 10 such that a common mode signal does not occur. This current source may also be used to feed a supply current to an AMR sensor.

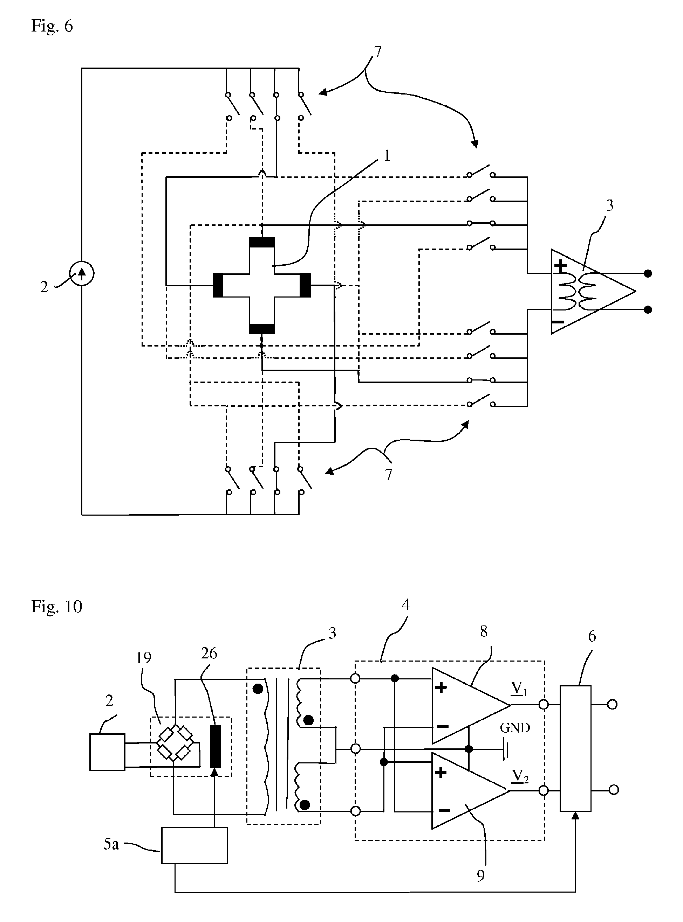

Fig. 10 shows a diagram of a second embodiment of a magnetic transducer according to the invention. In this second embodiment, the magnetic field sensor is an Anisotropic Magneto-Resistive (AMR) sensor 19. The magnetic-field-sensitive part of the AMR sensor 19 consists of four ferromagnetic thin-film resistors connected into a Wheatstone bridge. In addition to the bridge circuit, the AMR sensor 19 comprises further components like an internal set/reset strap 26 or an external coil and corresponding circuitry which allow the polarity of the bridge output voltage to be flipped by applying set and reset current pulses to the set/reset strap 26 or external coil. A set current pulse is defined as a positive current pulse which aligns the magnetic domains of the AMR sensor 19 in a forward easy-axis direction so that the sensor bridge's polarity is positive for positive fields resulting in a positive voltage across the bridge output connections. A reset current pulse is defined as a negative current pulse which aligns the magnetic domains of the AMR sensor 19 in a reverse easy-axis direction so that the sensor bridge's polarity is negative for positive fields resulting in a negative voltage across the bridge output connections.

An AMR sensor is therefore a magnetic field sensor having six terminals, namely two terminals for supplying a supply current to the Wheatstone bridge, two terminals for tapping the output voltage of the Wheatstone bridge, and two terminals for applying the set and reset current pulses to the set/reset strap 26 or external coil. In this sense, the external coil is a part of the AMR sensor. Such an AMR sensor 19 is available for example from Honeywell (sold as HMC1001). The electrical circuitry of the magnetic transducer comprises the same components as the first embodiment and may be realized in any of the different variants shown in Figs. 1 to 3, but the logic block 5 has partially other functions and is therefore configured as a logic block 5a differently from the first embodiment.

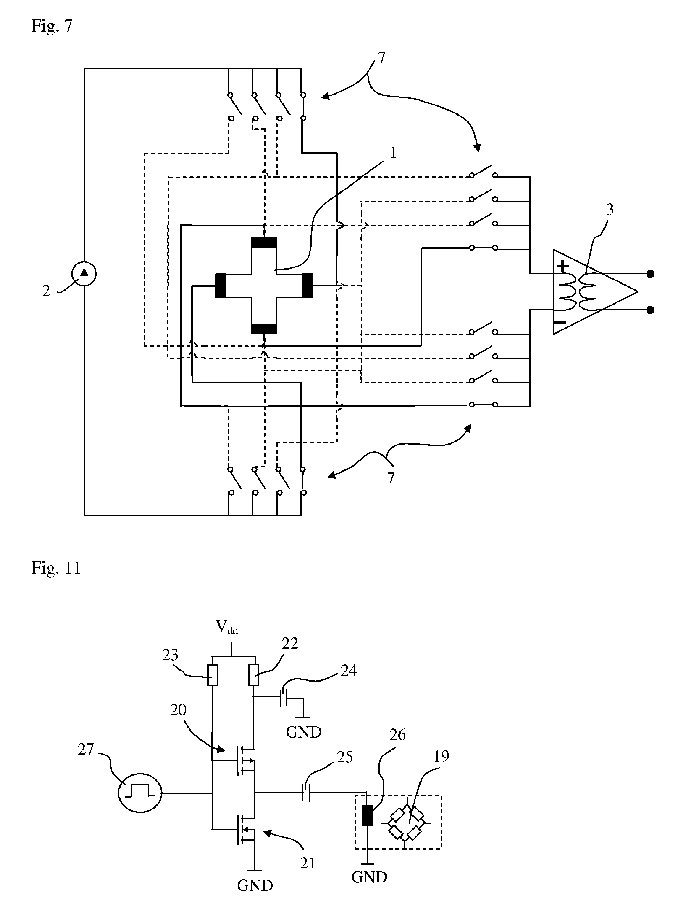

The logic block 5a is configured to produce set and reset pulses according to a predetermined frequency so that the output voltage of the AMR sensor 19 is an AC output signal. The logic block 5a is coupled to the phase sensitive detector 6 and sends a timing or clock signal corresponding to the frequency of the set and reset pulses to the phase sensitive detector 6. Fig. 11 shows an embodiment of a circuit capable of producing set and reset pulses with high peak currents. The circuit comprises two complementary power MOSFETs, namely a p-channel P-MOSFET 20 and an n-channel N-MOSFET 21 (available for example under the trade name IRF7105), two resistors 22, 23 and two capacitors 24, 25. The first resistor 22 and the two power MOSFETs 20, 21 are coupled in series, the two power MOSFETs 20, 21 are coupled as a CMOS (complementary MOS) inverter. The first capacitor 24 connects the node situated between the first resistor 22 and the P-MOSFET 20 with ground. The second capacitor 25 is coupled to a common node of the two power MOSFETs 20, 21 and to the strap 26 or external coil of the AMR sensor 19. The second resistor 23 is coupled to the positive supply voltage $V_{dd}$ and the gates of the power MOSFETs 20, 21. An output of a clock generator 27 is also coupled to the gates of the power MOSFETs 20, 21. Exemplary values are resistor 22 = 220 $\Omega$, resistor 23 = 20 k$\Omega$, capacitor 24 = 10$\mu$F, capacitor 25 = 220 nF. The clock generator 27 delivers pulses of a predetermined frequency. Every change in the pulse level of the generator 27 produces a set or reset pulse: If for a while the output voltage of the clock generator 27 is low, then the N-MOSFET 21 is non-conducting, the P-MOSFET 20 is conducting, so that the capacitor 25 is charged over the resistor 22 and the P-MOSFET 20 to a positive voltage almost equal to $V_{dd}$. When the output voltage of the clock generator 27 goes high, then the P-MOSFET 20 becomes non-conducting, the N-MOSFET 21 becomes conducting, and the capacitor 25 is rapidly discharged over the N-MOSFET 21. The discharging current flows through the strap 26 and produces the reset pulse for the AMR sensor 19. While the output voltage of the clock generator 27 stays high, the P-MOSFET 20 is non-conducting, and the capacitor 24 is charged over the resistor 22 to a positive voltage almost equal to $V_{dd}$. When the output voltage of the clock generator 27 goes low, then the N-MOSFET 21 becomes non-conducting, the P-MOSFET 20 becomes conducting, and the capacitor 25 is rapidly charged from the capacitor 24 over the P-MOSFET 20. The charging current flows through the strap 26 and produces the set pulse for the AMR sensor 19. The duration of a set or reset pulse is relatively short in comparison to the duration of one cycle of the clock signal.

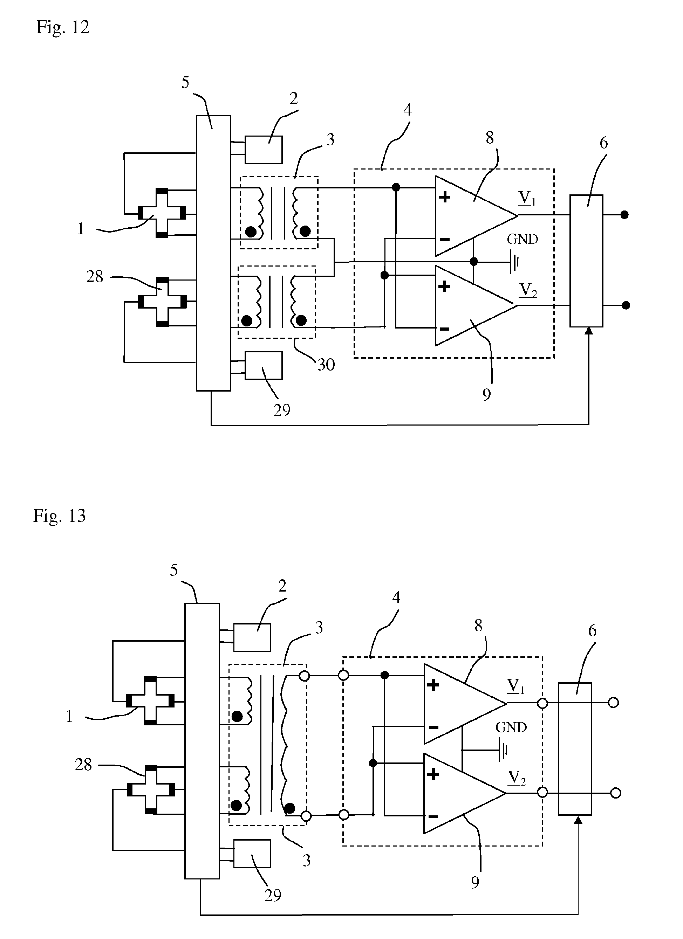

Fig. 12 shows a diagram of a third embodiment of a magnetic transducer according to the invention. In this embodiment, the magnetic transducer comprises two Hall elements 1 and 28, a first current source 2 providing a first supply current to the first Hall element 1 and a second current source 29 providing a second supply current to the second Hall element 28 while the other components of the electrical circuit are essentially the same as in the previous embodiments. In this embodiment, the transformer is composed essentially of two transformers 3 and 30, each having a primary winding with two input terminals and a secondary winding with two output terminals. The logic block 5 couples the first current source 2 and the primary winding of the first transformer 3 to the first Hall element 1 and the second current source 29 and the primary winding of the second transformer 30 to the second Hall element 28 to operate the Hall elements 1, 28 according to the spinning current method, so that the Hall elements 1, 28 each produce an AC output signal. Fig. 13 shows a variant of the third embodiment in which the transformer 3 is formed as a single component having one common magnetic core and only two output terminals, but it may also have a third middle output configured to be coupled to ground GND.

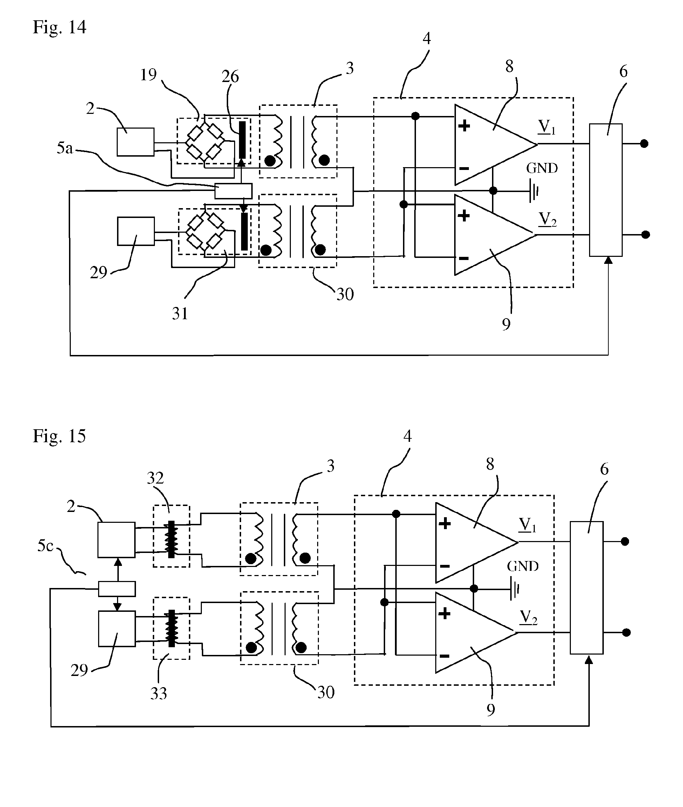

Fig. 14 shows a diagram of a fourth embodiment of a magnetic transducer according to the invention. In this embodiment, the magnetic transducer comprises two AMR sensors 19 and 31 instead of two Hall elements. The AMR sensors 19 and 31 are directly coupled to either the first current source 2 or the second current source 29 and to the primary winding of the first transformer 3 or second transformer 30. The logic block 5a operates the AMR sensors 19 and 31 in the same way as in the second embodiment, i.e. it applies set and reset pulses according to a predetermined frequency to the straps 26 or external coil of the AMR sensors 19 and 31. The transformers 3 and 30 may also be configured in any of the different ways shown in the previous embodiments.

Instead of the Hall element(s) or AMR sensor(s), the magnetic transducer may also comprise fluxgate sensor (s). A fluxgate sensor consists of a small, magnetically susceptible core wrapped by two coils of wire. A current source provides an alternating electrical current having a predetermined frequency which is passed through the first coil, driving the core through an alternating cycle of magnetic saturation; i.e., magnetised, unmagnetised, inversely magnetised, unmagnetised, magnetised, and so forth. This constantly changing magnetization induces an electrical voltage in the second coil, the phase of which depends on the external magnetic field to be measured. Fig. 15 shows a diagram of a fifth embodiment of a magnetic transducer according to the invention. In this embodiment, the magnetic transducer comprises two fluxgate sensors 32 and 33. The first coil of the fluxgate sensor 32 is coupled to the current source 2 and the second coil of the fluxgate sensor 32 is coupled to the primary winding of the first transformer 3. The first coil of the fluxgate sensor 33 is coupled to the current source 29 and the second coil of the fluxgate sensor 32 is coupled to the primary winding of the second transformer 30. The logic block 5c comprises a clock generator which controls the frequency of the current source's 2 output. The phase-sensitive detector 6 operates as a synchron demodulator. The magnetic transducer shown in Fig. 15 comprises two fluxgate sensors. However, a magnetic transducer having only one fluxgate sensor may also be formed in analogy with the previously shown embodiments.

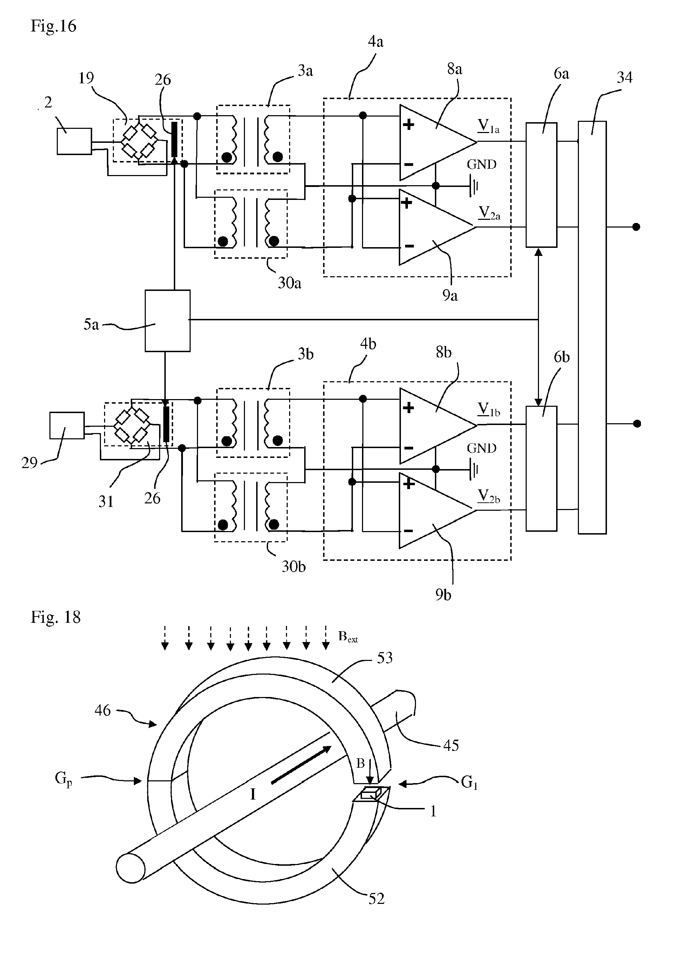

Fig. 16 shows a diagram of a sixth embodiment of a magnetic transducer according to the invention. In this embodiment, the magnetic field sensors are AMR sensors. The AMR sensor 19 is coupled to a first amplification chain comprising the same components as in the previous embodiments and labelled with the literal "a", the AMR sensor 31 is coupled to a second amplification chain comprising the same components as in the previous embodiments and labelled with the literal "b". The outputs of the phase sensitive detectors 6a and 6b are coupled to a voltmeter 34 or to an analog to digital converter. However, the transformers may be configured as in any of the previous embodiments. The magnetic field sensors could also be Hall elements or fluxgate sensors in which cases the logic block 5a would have to be modified for Hall elements or fluxgate sensors as shown above.

In all embodiments with two sensors of any kind, it is preferred to have one transformer having one single magnetic core, two primary windings and one secondary winding (like in Fig. 13) or possibly two secondary windings, although two separate transformers as shown in some of the embodiments are also possible. The reason is that the difference or sum of the two sensor signals should preferably be made as early in the signal chain as possible, which is therefore best done in the transformer core (at the magnetic flux level).

The magnetic transducer of the present invention may be used in various applications. If the magnetic transducer comprises two magnetic field sensors, it may be used for example as magnetic gradiometer. A magnetic gradiometer measures the gradient of the magnetic field. In an axial gradiometer, the two magnetic field sensors of the magnetic transducer are placed above each other on a common axis. The result coming from the magnetic transducer is the difference in magnetic flux density at that point in space which corresponds to the first spatial derivative. In a planar gradiometer, the two magnetic field sensors are placed next to each other. The magnetic transducer may also be used as a current transducer in that it measures the strength of the magnetic field produced by a current flowing through a conductor. In this case, the current transducer preferably comprises a magnetic circuit having at least one air gap in which the magnetic field sensor(s) of the magnetic transducer are placed. Such a current transducer may be formed as a clamp-on current transducer or ammeter.

In any application using two magnetic field sensors, the coupling of the second magnetic field sensor to the associated transformer can be done as shown in the various embodiments if the direction of the magnetic field to be measured is the same for both magnetic field sensors. If the direction of the magnetic field at the places of the two magnetic field sensors runs in opposite directions, then the polarity of the output signal of the second magnetic field sensor is reversed with respect to the polarity of the output signal of the first magnetic field sensor. In this case either the input current or the output voltage of one of the two magnetic field sensors needs to be inverted (which can be done for example by changing the coupling scheme to the current source or to the transformer or by modifying the winding direction of the transformer).

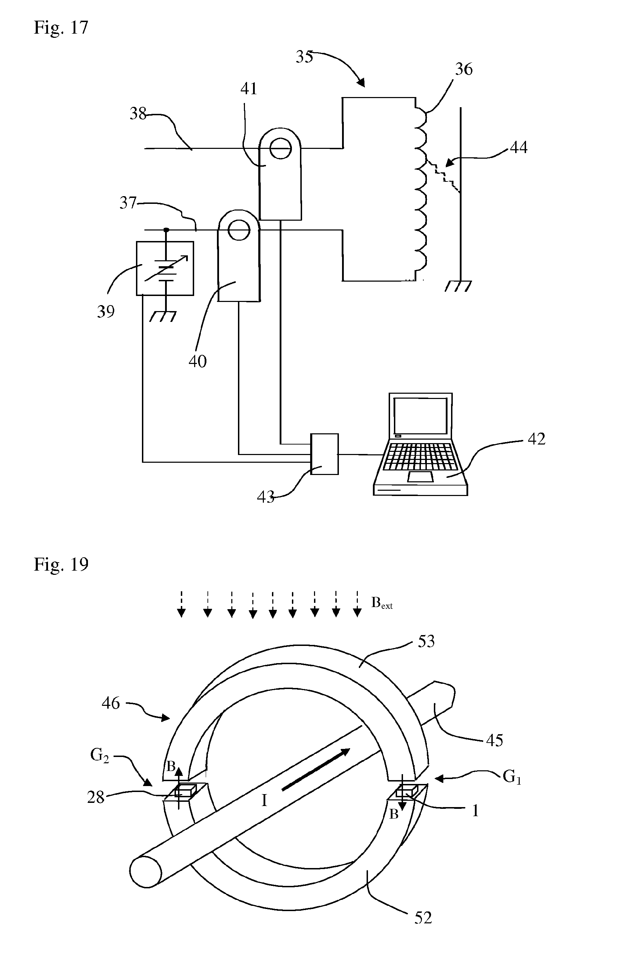

The magnetic transducer of the present invention may also be used to detect a current leakage path in a machine. Fig. 17 shows an electrical machine 35 and a system for detecting a current leakage path in the machine 35. The machine 35 usually has a complex impedance, i.e. an impedance with high capacitance and/or inductance. In operation, the electrical machine 35 is coupled to a power supply system which may have one, two or more phases. The system of the present invention is used to detect a leakage current and/or find the location of the leakage current which may occur in the current circuit of one of these phases. For the sake of simplicity, the machine 35 in Fig. 1 is shown as having a single winding 36 that is coupled to a phase of the power supply system by means of a first cable 37 and a second cable 38. When the machine 35 is running in normal operation, a current is supplied from the power supply system through the cable 37 to the machine 35, flows through the winding 36 of the machine 35 and is discharged from the electrical machine 35 back to the power supply system through the cable 38.

During manufacture or in the course of normal operation of the electrical machine 35 a resistance leakage path may develop somewhere in the machine 35. The present invention is related to the detection and location of the resistance leakage path at an early time, i.e. when the resistance is still very high so that a damage of the electrical machine 35 can be avoided. For the detection of a possible leakage current, the electrical machine is decoupled from the power supply system and a test environment with a system according to the invention is set up which is described in the following in detail.

The system according to the invention comprises a high voltage DC source 39, a first clamp-on ammeter (current transducer) having a head 40 to fit around a first cable and a second clamp-on ammeter (current transducer) having a head 41 to fit around a second cable, and a control unit for controlling the output of the high voltage DC source 39, the heads 40 and 41 and processing their output signals. Each of the heads 40 and 41 delivers an output signal that is responsive to an electrical current flowing through the respective cable. In the present embodiment, the control unit comprises a computer 42 and an interface 43 coupling the high voltage DC source 39 and the heads 40 and 41 to the computer 42. The heads 40 and 41 are coupled to the interface 43 via signal lines and control lines, so that the computer 42 can control each step of a leakage measurement and read out the output signals of the heads 40 and 41. The computer 42 or the interface 43 is configured to build the difference between the output signal of the first head 40 and the output signal of the second head 41. A difference that is greater than a predetermined threshold value indicates that there is a leakage current. The threshold value may for example be the smallest leakage current that the system is able to detect. A possible ohmic leakage path 44 between a location in the winding 36 and ground or earth is shown for illustrative purposes. The heads 40 and 41 have an identical structure, therefore their structure is described in the following with reference to the head 40. Fig. 17 shows the test situation in which the high voltage DC source 39 is coupled to the first cable 37 and ground, the head 40 is fit around the first cable 37 and the head 41 is fit around the second cable 38 of the electrical machine 35, but the heads 40 and 41 may be fit around the winding 36 at any suitable location to precisely locate a current leakage path, as will be explained later. Each of the heads 40 and 41 comprises at least one current transducer, and each current transducer comprises at least one magnetic transducer.

In the following embodiments and illustrations, for illustration purposes the magnetic field sensors used in the magnetic transducers are Hall elements, but the magnetic field sensors may also be AMR or fluxgate sensors. A magnetic transducer as used in the following comprises one or more magnetic field sensor(s) and electrical circuitry to operate the magnetic field sensor(s).

Fig. 18 shows a schematic view of the principal mechanical configuration of a current transducer according to the state of the art. The current transducer comprises a ring-shaped ferromagnetic core 46 with an air gap $G_1$, in which the magnetic field sensor, e.g. a Hall element 1, of the magnetic transducer is placed. The core 46 encloses a cable 45, in which a current I flows which should be measured. In a clamp-on current transducer, the core 46 consists of at least two approximately equal half-circular pieces 52 and 53, which can be assembled (clamped) around the cable 45. In the present embodiment , there are two air gaps $G_1$, $G_p$ between the pieces 52 and 53 of the core 46. While the air gap $G_1$ is used to receive the magnetic field sensor, the air gap $G_p$ is a parasitic one, which exists because of imperfections of the surfaces of the pieces 52 and 53 of the core 46, which touch each other. In a current transducer designed for permanent and non clamp-on use, the ferromagnetic core 46 is usually made of one piece, and the parasitic air gap $G_p$ does not exist. A current I flowing through the cable 45 produces a magnetic field B in the air gap $G_1$, which is measured by the magnetic field sensor of the magnetic transducer. The output signal of the magnetic transducer is proportional to the current I. The proportionality factor is called the sensitivity of the current transducer.

There are two major deficiencies of such a current transducer. One deficiency is a dependence of its sensitivity on the position of the enclosed cable 45 within the core 46. For example, if the cable 45 moves from the center of the core 46 toward the air gap $G_1$, then the magnetic sensor will be exposed to a stronger magnetic field associated with the current I, and the current measured by the current transducer will appear stronger. The other deficiency is a dependence of the output signal of the current transducer on an external magnetic field. For example, with reference to Fig. 18, an external magnetic field $B_{ext}$ having the same direction as the internal magnetic field B will produce in the air gap $G_1$ a parasitic magnetic field $B_{par}$. The parasitic magnetic field $B_{par}$ cannot be distinguished from the internal magnetic field B, which should be measured. For a core made of a very high-permeability material and with very small air gaps, the parasitic magnetic field $B_{par}$ is approximately given by the following equation:

$$B_{par} \approx D_{ext}^2 / (a \times b) \ \times \ (g_p / g_1) \ \times B_{ext}$$

Here $D_{ext}$ denotes the external diameter of the core 46, a and b are the dimensions of the rectangular cross-section of the core 46, and $g_1$ and $g_p$ are the thicknesses of the air gaps $G_1$ and $G_p$, respectively. The term $D_{ext}^2 / (a \times b)$ comes from the effect of the concentration of the external magnetic flux into the core 46. This will be further referred to as the magnetoconcentration effect. The term $(g_p / g_1)$ represents the sharing ratio of the concentrated magnetic flux among the two air gaps $G_1$ and $G_p$.

When the structure shown in Fig. 18 is used in a clamp-on current transducer, it shows a third major deficiency, which is a poor repeatability of the sensitivity after repeated clamping-on and off of the core 46. This comes from the fact that the sensitivity of the current transducer is proportional to the factor $1 / (g_1 + g_p)$; and it is very difficult to achieve the mechanical precision of the clamping-on mechanism, which will insure the repeatability of the sum $(g_1 + g_p)$ better than a few percent.

A known attempt to mitigate the first two deficiencies is illustrated in Fig. 19. The core 46 of the transducer consists of two half-circular parts 52 and 53 of approximately equal size, having between them two equal air gaps $G_1$, $G_2$, and in each of the gaps there is a magnetic field sensor, e.g. as shown a Hall element 1 or 28. Such a structure is more robust with respect to the positioning of the cable 45. But in order to suppress the parasitic influence of the external magnetic field a perfect symmetry of the systems gap $G_1$ - Hall 1 and gap $G_2$ - Hall 2 is required, which is difficult to achieve, particularly in a clamp-on version of the current transducer. Moreover, in the case of a clamp-on transducer, this structure also suffers from poor repeatability.

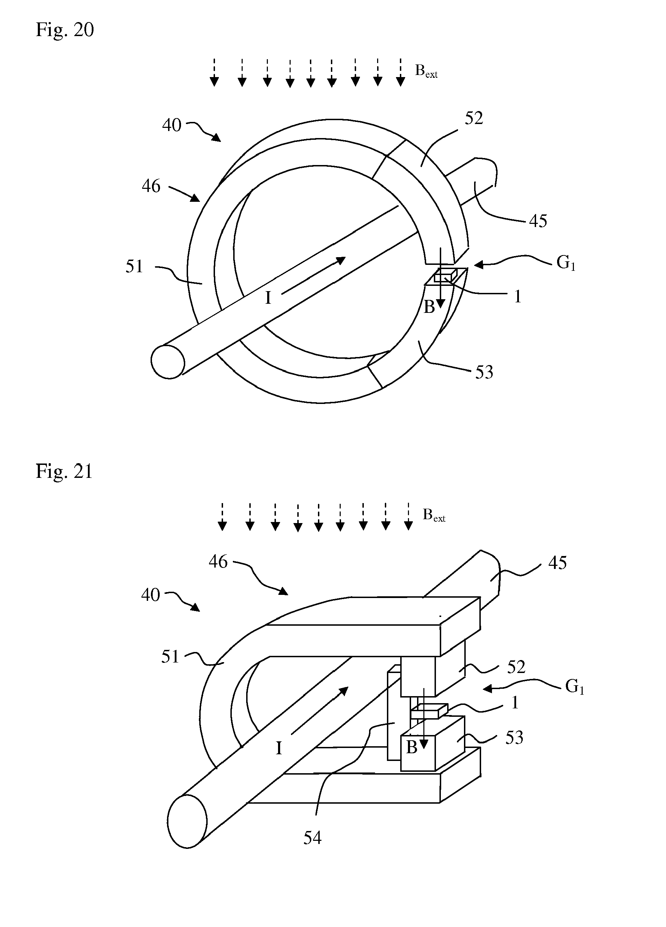

Fig. 20 shows a first embodiment of a measurement head 40 of a current transducer according to the invention. The head 40 has an approximately circular core 46 consisting of three ferromagnetic pieces 52 to 51. The piece 53 has the form of an arc longer than a half-circle. The two pieces 52 and 53 are arcs shorter than 1/4 of a circle. The contact surfaces between the pieces 53 and 51 and between the pieces 53 and 52 are approximately parallel with each other. The consequences of these measures are as follows:

- The form of the ferromagnetic piece 51 looks like the character C. This results in the fact that an external magnetic flux $\Phi_{ext}$, caused by the external magnetic field $B_{ext}$, is channeled to the side of the magnetic core 46, which has no air gap (which is the left side in Fig. 20). Put otherwise, the piece 51 shields the Hall element 1 from the external magnetic field $B_{ext}$; such a core, with a C-shaped piece 51, has a self-shielding effect.

- The two pieces 52 and 53 can be rigidly connected to each other (by non-magnetic means which are not shown), but with the air gap $G_1$ formed between them and the magnetic field sensor placed in the air gap $G_1$. This solution allows the disassembly of the head into two parts at a location other than the air gap $G_1$ so that the width of the air gap $G_1$ always remains the same and is thus independent from any mechanical alignment errors when the head is re-assembled.

- The areas of the two parasitic air gaps $G_{p1}$ and $G_{p2}$ at the contact surfaces between the pieces 51 and 52 and between the pieces 51 and 53, respectively, are preferably much larger than in the case shown in Fig. 20. This also results in a better repeatability of the clamp-on operations.

- If the arc of the piece 53 is not longer than a half-circle, then the clamp-on clearance of the core 46 reaches its maximum which is as large as the inner diameter of the core 46.

Fig. 21 shows a variation of the embodiment shown in Fig. 20 where the piece 51 of the core 46 has a U-shape that completely encloses the current-carrying cable 45 on three sides. The pieces 52, 53 are short and approximately straight. This solution offers further improved immunity to external magnetic fields, since an external magnetic flux passes preferentially through the round part of the piece 51 and so circumvents the magnetic field sensor. Put otherwise, such a core 46, with a U-shaped piece 51, has a strong self-shielding effect. The pieces 52, 53 are rigidly connected to each other by non-magnetic means 54 such as to form the air gap $G_1$ between them and the magnetic field sensor is placed in the air gap $G_1$.

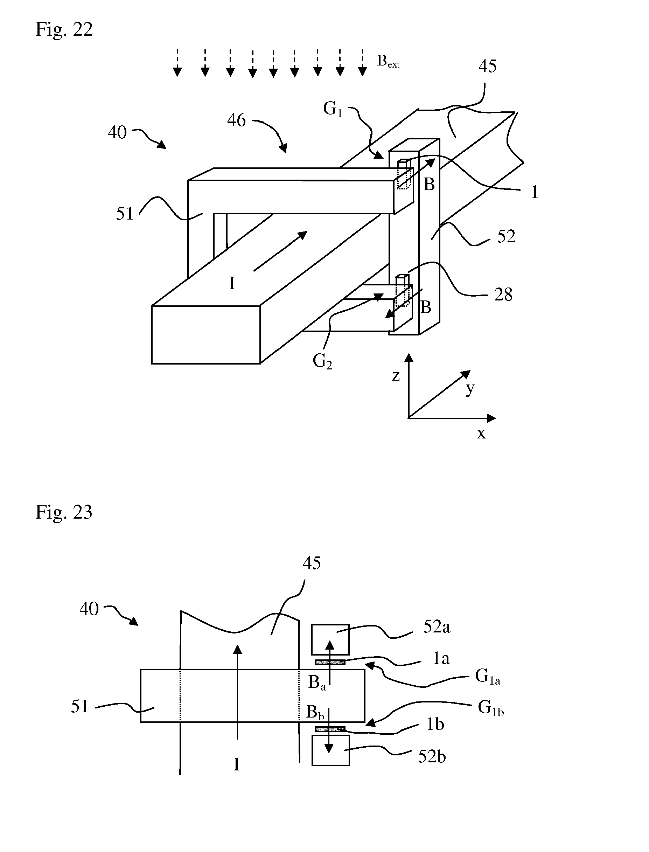

Fig. 22 shows an embodiment where the core 46 is composed of two pieces 52 and 53, the first piece 51 having a U-shape and the piece 52 being a straight piece. The shape and/or the cross-section of the U-shaped piece 51 is rectangular, for example. The piece 52 is positioned on one side of the legs of the U-shaped piece 51 so that the part of the magnetic circuit having the air gaps $G_1$, $G_2$ is rotated by 90° with respect to the U-shaped piece 51. Therefore, the magnetic field B produced by the current I flowing in the enclosed cable 45 points in a direction parallel with the longitudinal axis of the cable 45 at the positions of the Hall elements 1 and 28 (which is the $\gamma$-axis in the shown co-ordinate system). This structure is self-shielded by the pieces 51, 52 from the x- and z-components of an external magnetic field $B_{ext}$. Only the $\gamma$-component of an external magnetic field is "seen" by the Hall elements 1 and 28. But the pieces 51, 52 of the ferromagnetic core 46 are short in the $\gamma$-direction, so that the magnetoconcentration effect in that direction is the smallest. Moreover, since the directions of the magnetic field B produced by the current I are opposite in the two Hall elements 1 and 28, and the directions of the $\gamma$-component of an external field $B_{ext}$ are the same, the signals due to the external magnetic field $B_{ext}$ can be cancelled. Therefore, this solution offers a further improved immunity to external magnetic fields, particularly to the magnetic fields produced by other cables positioned parallel with the cable 45 which do not have a substantial $\gamma$-component.

Fig. 23 shows a top view of a variation of the embodiment of Fig. 22 where there are two straight pieces 52a, 52b positioned at the opposite sides of the legs of the piece 51 of the core 46, so that four air gaps (only two air gaps $G_{1a}$, $G_{1b}$ are visible) are formed, each having one Hall element 1a or 1b, 28a, 28b (not visible). Since the direction of the magnetic fields $B_a$, $B_b$ produced by the current I are opposite in the Hall elements 1a, 1b, and the directions of the $\gamma$-component of an external field $B_{ext}$ are the same, the signals due to the external magnetic field can be cancelled. Therefore, this solution offers still further improved immunity to external magnetic fields independently on its direction. Moreover, due to the symmetry of the positions of the Hall elements 1a or 1b, 28a, 28b with respect to the piece 51 of the core 46, the repeatability of the clamping-on operation is much improved. With this solution, the two pieces 52, 53 are arranged symmetrically with respect to a symmetry plane of the piece 51 on opposite sides of the piece 51.

A plurality of heads of a current transducer as those illustrated in Figs. 20 to 23 may be used in parallel. The heads are positioned approximately parallel to each other along the axis of the cable 45. Each of the heads may be rotated around the axis of the cable 45 for an individual or the same angle, for example for an angle of 90° or 180°. The magnetic sensors of the heads can be operated in parallel. Alternatively, each magnetic sensor, or a pair of magnetic sensors, may be connected to a separate electronic circuit to build several magnetic transducers; and the signal outputs of all the magnetic transducers are summed up, and this sum of the signals represents the output signal of the whole current transducer system. In comparison with individual current transducers shown in Figs. 20 to 23, this solution offers a better signal to noise ratio, improved immunity to external magnetic fields, and lower sensitivity to the position of the enclosed current-carrying cable 45.

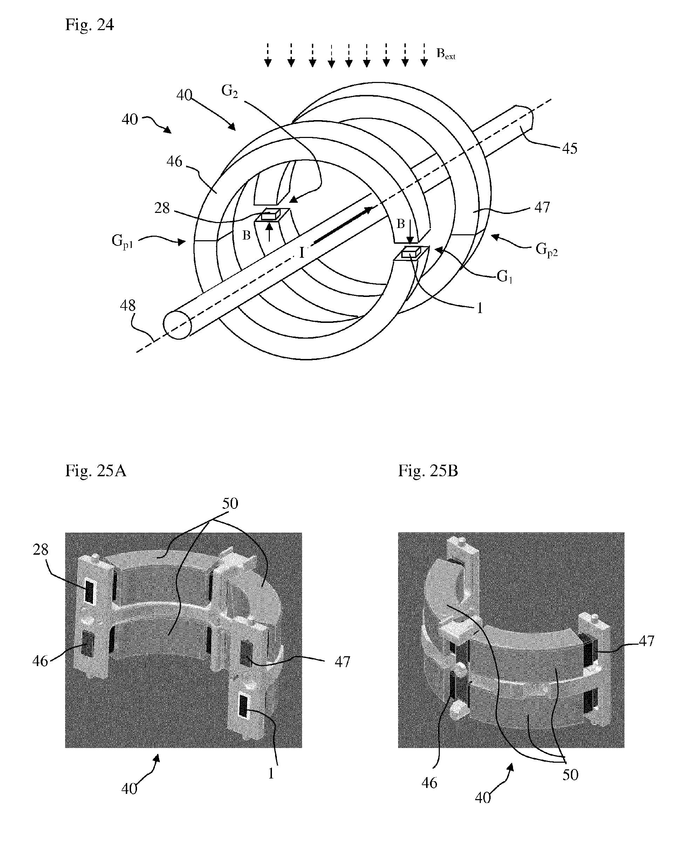

Fig. 24 shows an example of the head 40 of a current transducer composed of two core-structures like those shown in Fig. 18. The two core-structures are positioned approximately parallel to each other along the axis of the cable 45. The second core 47 is rotated around the axis of the cable 45 for an angle of 180° with respect to the first core 46. To make a measurement, the head 40 is to be clamped around the cable 45.

The head 40 of Fig. 24 comprises two ferromagnetic cores 46 and 47 forming two magnetic circuits each having an air gap $G_1$ or $G_2$, respectively, and having a parasitic air gap $G_{1p}$ or $G_{2p}$, respectively. The cores 46, 47 are placed at a distance from each other along the direction of the cable 45. A first Hall element 1 is placed in the air gap of the first core 46, a second Hall element 28 is placed in the air gap of the second core 47. A current flowing through the cable 45 produces a magnetic field B. The air gaps $G_1$ and $G_2$ of the two cores 46, 47 are situated preferably at diametrically opposite sides with respect to a center axis 48 so that the magnetic field B produced by the current I flowing in the cable 45 points in opposite directions at the places of the Hall elements 1 and 28 (illustrated by arrows pointing in opposite directions). The difference of the output signals of the two Hall elements 1 and 28 is therefore independent from an external magnetic field $B_{ext}$ which may be present.

Mechanically, the head 40 is comprised of at least two parts that are detachable from each other such that it is possible to mount the head 40 around the cable 45. This means that the cores 46, 47 consist each of at least two ferromagnetic pieces. Figs. 25A and 25B show the two parts of the head 40 according to a preferred embodiment in which each of the cores 46, 47 comprises two ferromagnetic core halves of a half-circular shape and about the same size. The two parts of the head 40 each comprise a basic body on which the core halves are mounted in a floating manner and springs are provided to ensure a reproducible contact between the core halves. The first Hall element 1 is mounted on an end of a core half of the core 46, the second Hall element 28 is mounted on an end of a core half of the core 47 of the same head part, and as can be seen on opposite lying ends of the core halves. When the two parts of the head 40 are assembled, a first end of the first core half and a first end of the second core half of the core 46 are in contact with each other while the second end of the first core half and the second end of the second core half are separated by the air gap. The same holds for core 47. The Hall elements 1, 28 are each bordered by a protruding frame or another distance keeping means that defines the width of the respective air gap in the assembled condition of the head 40. The basic bodies of the two parts have self-aligning means, e.g. a pin and a conical opening receiving the pin, and springs to generate an attracting, resilient force between the two parts in the connected state. This ensures on the one hand side that the first ends of the core halves are reproducibly contacted and on the other hand side that the width of the air gaps is always the same when the two parts of the head 40 are clamped around the cable 45.

The core 46 shown in Fig. 18 can easily be substituted by any of the cores shown in Figs. 20 to 24. Moreover, additional such cores can be added. This brings about further improvements in immunity to external magnetic fields and signal to noise ratio, lower sensitivity to the position of the enclosed current-carrying cable 45, and better repeatability of a clamped-on version of the current transducer.

The material of the ferromagnetic cores 46, 47 must have a high relative permeability of at least 1000 because a high relative permeability helps to shield the Hall elements 1, 28 from any possible environmental magnetic field. Moreover, the ferromagnetic cores 46, 47 should ideally have no remanent field. Since this is difficult to achieve, the ferromagnetic cores 46, 47 should be easily demagnetizable. For this purpose, coils 50 are wound on each of the four core halves and the head 40 is provided with the necessary electronic circuitry to operate the coils 50 in a demagnetization mode to demagnetize the ferromagnetic cores 46, 47. The classical method to demagnetize a core is to magnetize it several times in opposite directions with decreasing excitations. This can be done for example with a resonant circuit comprising the coils 50 and a capacitor by linearly increasing the frequency of the current flowing through the resonant circuit until the resonant frequency of the resonant circuit is reached, staying there a few periods and then exponentially reducing the current.

The clamp-on ammeters may be operated in the so-called open loop mode or in the closed loop mode. In the latter, the coils 50 are supplied during a measurement with a coil current that creates in the air gap of the respective magnetic core a magnetic field opposite to the magnetic field created by the current flowing through the cable 45. The strength of the coil current is adjusted such that the Hall voltage of the Hall element placed in the respective air gap is equal to zero.

In all these embodiments of the head 40, the head 40 may also have a second and/or third, etc., Hall element placed in the air gap adjacent to the Hall element 1. The use of the additional Hall element(s) increases the signal to noise ratio. Furthermore, as illustrated in several figures, the shape of the ferromagnetic cores 46 and 47 is not limited to the toroidal shape. The ferromagnetic core(s) may have any other suitable shape, for example a rectangular shape or D-shape.

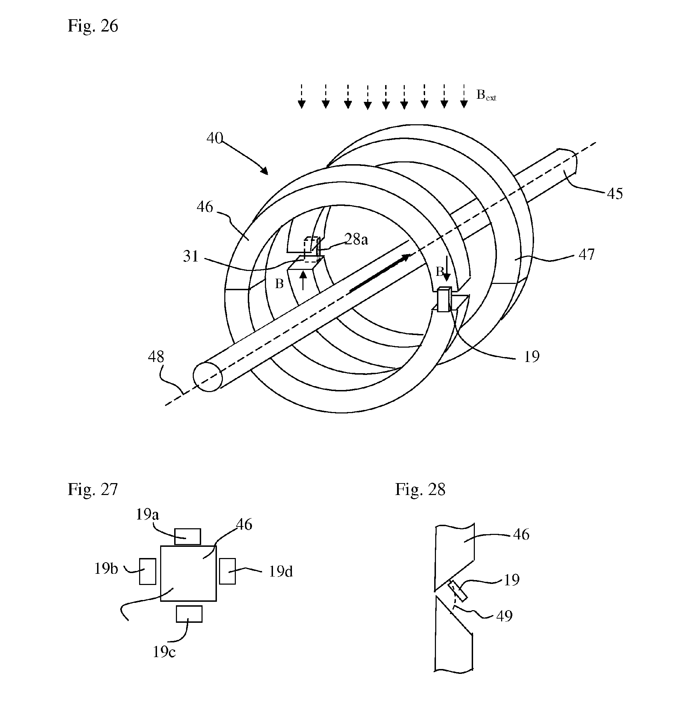

The Hall element(s) may be replaced with AMR sensor(s) or fluxgate sensors. Fig. 26 shows an embodiment of such a head 40 with AMR sensors 19, 31. As the AMR sensors 19, 31 are usually sensitive to a direction of the magnetic field running parallel to the upper surface of their IC housing, they are preferably not placed in the air gaps of the ferromagnetic cores 46, 47 but adjacent the air gaps  so that the air gaps can be kept small. The AMR sensors 19, 31 therefore lie in the stray magnetic field surrounding the space near the air gaps. As shown in fig. 27 in a top view for core 46, this may allow four AMR sensors 19a to 19d to be mounted at the four edges limiting the face of the cores 46, 47 facing the air gap. The four AMR sensors 19a to 19d may be coupled in parallel and operated like one AMR sensor. Fig. 28 shows yet another way to mount an AMR sensor. In this case, the end faces of the core 46 do not extend parallel to each other, but include an angle so that the housing of the AMR sensor 19 finds enough room in the air gap between the end faces. The housing of the AMR sensor 19 is oriented in the proper way to align the AMR sensor 19 with the magnetic field lines 49 in the air gap which leave the end faces of the core 46 almost perpendicularly and are therefore curved.

With the head 40 (and also head 41) the magnetic field sensor(s) is/are placed at the air gap which means that Hall elements are preferably placed in the air gaps, AMR sensors, flux-gate sensors, and magnetoimpedance sensors are preferably placed adjacent the air gaps. But there are Hall magnetic sensors (such as vertical Hall or Hall combined with planar magnetic concentrators), which are sensitive to an in-the-chip-plane component of the magnetic field; such a Hall sensor should also be placed adjacent the air gap. Also, there are AMR magnetic sensors (such as Honeywell type HMC 151z), which are sensitive to an orthogonal-to-the-chip-plane component of the magnetic field; such an AMR sensor should be placed in the air gap.

The system described above with each head 40, 41 having two cores 46 and 47 and two Hall elements 1, 28 is capable of detecting a leakage current down to approximately 1 $\mu$A (microampere). If a system is used with which each head 40, 41 has only one ferromagnetic core 46 with an air gap and one magnetic field sensor placed in the air gap or besides the air gap in the stray magnetic field then a leakage current down to the order of 100 $\mu$A can be detected. Fig. 25 shows a schematic view of the principal mechanical configuration of such a head 40 having one magnetic field sensor only, in this case a Hall element 1.

The leakage state of the machine 35 is tested during manufacture and/or during normal operation from time to time, e.g. according to a specific maintenance scheme. For this test, the machine is shut down and decoupled from the power supply system. The leakage measurement is performed separately for each phase of the power supply system one after the other, and is described here for the first phase only. It is to be understood that the cables 37 and 38 and the winding 36 carry the first phase. The leakage measurement set-up for the first phase is illustrated in Fig. 1, it usually comprises preparation steps A to E, wherein steps C and D are optional and may also be performed in reverse order, the measurement comprised of steps F and G, and a final step H:

A) fitting the head 40 of the first clamp-on ammeter around a first cable and fitting the head 41 of the second clamp-on ammeter around a second cable;
B) coupling a first terminal of the high voltage DC source 39 to the first cable and coupling a second  terminal of the high voltage DC source 39 to ground;
The second cable remains uncoupled. This state is shown in Fig. 17.
C) demagnetizing the ferromagnetic cores 46, 47 of the heads 40 and 41 by feeding an appropriate AC current through the coils 50;
D) calibrating the heads 40 and head 41;
E) ramping up the high voltage DC source 39;

The ramping up occurs under the control of the control unit. Ramping up means that the output voltage V of the high voltage DC source 39 is increased until the output voltage V has achieved a predetermined value. When the high voltage DC source 39 is ramped up a loading current $I_L$ flows through the cables 37 and 38 that loads the stray capacitances, the size of which is denoted here as C. This loading current $I_L$ must be kept small enough to avoid a permanent magnetization of the ferromagnetic cores 46, 47. This is achieved preferably by linearly and smoothly ramping up the output voltage V of the high voltage DC source 39 at a constant rate, dV/dt, so that the loading current $I_L$ which is proportional to C * dV/dt is maintained at less than a critical value $I_{max}$. A typical value for $I_{max}$ is about 100mA

F) operating the heads (40, 41) to receive a first output signal proportional to a current flowing through the first cable and a second output signal proportional to a current flowing through the second cable,

G) building a difference between the first output signal and the second output signal, and

H) ramping down the high voltage source 39.

The ramping down occurs also under the control of the control unit such that the current that flows to unload the stray capacitances is always smaller than $I_{max}$.

If in an additional step K when the high voltage DC source 39 is ramped down the output signal of the clamp-on ammeters is measured, an offset $S_{Offset}$ of the output signals S of the clamp-on ammeters can be eliminated. The offset $S_{Offset}$ designates that part of the signal that is independent from the current flowing through the cable. This is explained with reference to the first clamp-on ammeter. When the high voltage DC source 39 is ramped up, the output signal of the first clamp-on ammeter is $S_1 = S_{up} = S_{Offset} + S_C$, where $S_C$ denotes the part of the output signal S that is proportional to the current flowing through the cable. When the high voltage DC source 39 is ramped down (= zero voltage between its terminals), the output signal of the clamp-on ammeter is $S_1 = S_{down} = S_{Offset}$. By building the difference $\Delta S_1 = S_{up} - S_{down} = Sc$, the offset $S_{Offset}$ is eliminated.

In a preferred mode of operation, steps E to K are repeated a number n of times thus getting many measurements which can be averaged with the advantage of an increased signal to noise ratio and therefore increased sensitivity.

In Fig. 17, the head 40 is fit around the first power cable 37 and the head 41 is fit around the second power cable 38. This allows to detect whether a leakage current occurs anywhere in the winding 36 of the machine. No current flows through the cable 38 because the cable 38 is uncoupled. If there is no leakage so that no leakage current flows through the leakage path 44 then no current flows through the cable 37: The difference of the output signals of the heads 40 and 41 is 0. If there is a leakage so that a leakage current $I_{leak}$ flows through the leakage path 44, then the leakage current $I_{leak}$ flows also through the head 40: The difference of the output signals of the heads 40 and 41 is proportional to the leakage current $I_{leak}$ and therefore different from 0.

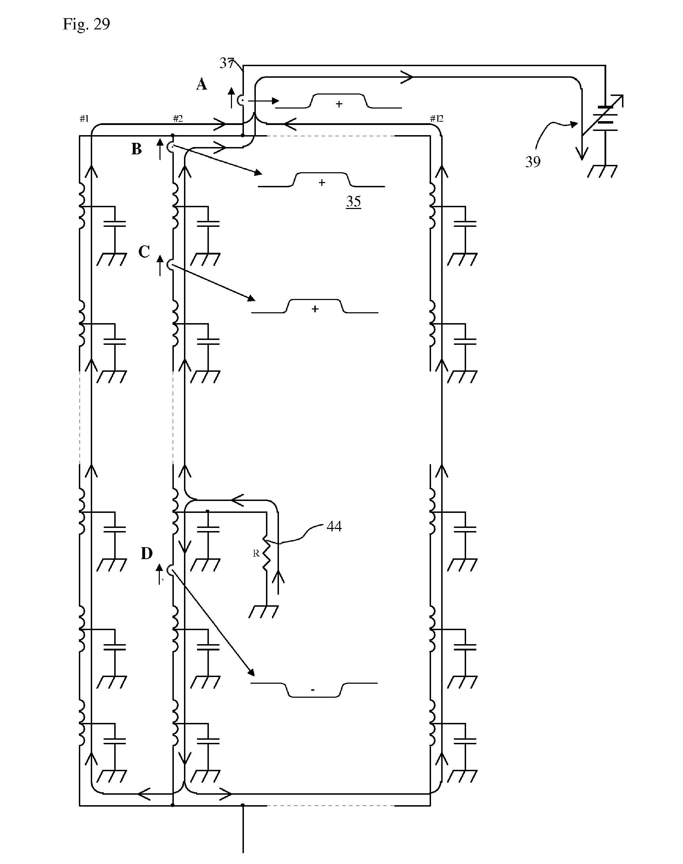

There are large electrical machines 35 with a single winding or several windings coupled in series which are physically accessible at different locations. The equivalent circuit diagram of such an electrical machine 35 and the system of the invention during the test are shown in Fig. 29. The machine 35 comprises a plurality of windings, some of them coupled in series and some of them coupled parallel (In Fig. 29, there are twelve parallel current paths labelled #1 to #12 having a number of individual windings). Electrical stray capacitances are shown for illustration purposes as individual capacitors coupled to the windings. A resistor R represents an ohmic leakage path 44. The windings, capacitors and resistors are shown with their usual electrical symbols. A first terminal of the high voltage DC source 39 is coupled to a cable connected to the windings 36 of the machine and a second terminal of the high voltage DC source 39 is connected to ground. Separate lines and arrows indicate the direction and paths of the leakage current that originates from the leakage path 44. A first clamp-on ammeter is clamped at a position A around the cable 37 coupling the windings to the high voltage DC source 39. A second clamp-on ammeter is clamped at one of positions B to D after the other around the respective cable and a measurement made. Arrows placed besides the four positions A to D illustrate the orientation of the clamp-on ammeter. Four insert-diagrams associated with the four positions A to D illustrate the strength and sign of the DC current that is measured with the clamp-on ammeter at the associated position. As can be seen the sign of the current shown in the diagram associated with position D is opposite to the sign of the current shown in the other diagrams. So the leakage path 44 can be identified between positions C and D.

It is possible to use only two clamp-on ammeters and make one leakage measurement after the other wherein the first clamp-on ammeter is placed at position A and the second clamp-on ammeter is placed at positions B to D one after the other. However, this is a time consuming process because the high voltage DC source 39 needs to be ramped up and down each time. Therefore, it is preferred to use several clamp-on ammeters placed at positions B to D simultaneously. If a leakage current is detected and the leakage location found then only the machine part with the leakage path needs to be disassembled, repaired or replaced, and reassembled. It is to be noted that also the first clamp-on ammeter may be placed at different positions in the machine 35 in order to more quickly locate the leakage path 44.

The current leakage detection system according to the invention provides several features and advantages:

- Several measures contribute to the cancellation of the common mode signal, among them in particular the use of two ferromagnetic cores with two Hall elements or AMR or fluxgate or magnetoimpedance sensors per head, the design of the electronic circuit for full differential operation, the magnetic field sensor biasing method providing the output voltage at the terminals of the magnetic field sensor as voltages of equal size but opposite sign with respect to ground, the transformer coupling between the magnetic field sensors and the preamplifier.

- The transformer coupling of the voltage terminals of the magnetic field sensor to the preamplifier allows the electronic circuit to achieve an equivalent input noise very close to the thermal noise of the resistance of the magnetic field sensor.

- The electronic circuit operates in full differential mode. The operation of each ammeter is analogous to the operation of a differential amplifier, where the useful magnetic field corresponds to a differential voltage and an external magnetic field corresponds to a common mode voltage which allows an effective separation of the wanted magnetic field from external magnetic fields.

- The use of two cores results in a significant reduction of the influence of external magnetic fields and therefore increases the sensitivity of the system.

**Claims**

1. Current transducer for measuring a current flowing through a cable (45), comprising
a head (40) comprising a single ferromagnetic core (46) with an air gap ($G_1$) and a magnetic field sensor placed at the air gap ($G_1$), wherein
the ferromagnetic core (46) is composed of a first ferromagnetic piece (51) having a U-shape or a C-shape and two further ferromagnetic pieces (52, 53), the two further ferromagnetic pieces (52, 53) rigidly connected to each other by non-magnetic means (54) such as to form the air gap ($G_1$) between them and detachable from the first piece (51).

2. Current transducer for measuring a current flowing through a cable (45), comprising
a head (40) comprising a ferromagnetic core (46) with at least two air gaps ($G_1$, $G_2$) and a magnetic field sensor placed at each of the air gaps ($G_1$, $G_2$), wherein
the ferromagnetic core (46) is composed of a first ferromagnetic piece (51) having a U-shape or a C-shape and at least one further ferromagnetic piece (52, 53), and
a direction of the magnetic field produced by the current flowing through the cable (45) in the air gaps ($G_1$, $G_2$) runs substantially parallel or antiparallel to a longitudinal axis (48) of the cable (45).

3. Current transducer according to claim 2, wherein the at least one further piece (52, 53) are two pieces (52, 53) arranged symmetrically with respect to a symmetry plane of the first piece (51) on opposite sides of the first piece (51).

4. Current transducer according to claim 2 or 3, wherein the at least one further piece (52, 53) is detachable from the first piece (51).

5. Current transducer for measuring a current flowing through a cable (45), comprising
a head (40) comprising at least two ferromagnetic cores (46, 47) each composed of at least one first piece (51) and at least one further piece (52, 53), each core (46, 47) having an air gap ($G_1$, $G_2$) and a magnetic field sensor placed at the air gap, wherein the air gaps ($G_1$, $G_2$) of the two ferromagnetic cores (46, 47) are situated at diametrically opposite sides with respect to a center axis (48) so that the magnetic field produced by the current flowing in the cable (45) points in opposite directions at the places of the magnetic field sensors.

6. Current transducer according to any of claims 1 to 5, further comprising
a transformer (3) coupled to the magnetic field sensor(s),
a fully differential preamplifier (4) coupled to the transformer (3),
a phase sensitive detector (6) coupled to the preamplifier (4), and
a logic block (5) configured to operate the magnetic field sensor(s) to provide an AC output signal, wherein the magnetic field sensor(s) is/are either a Hall element or an AMR sensor or a fluxgate sensor.

7. Current transducer according to any of claims 1 to 6, further comprising at least one coil (50) wound around the ferromagnetic core(s) (46; 47), electronic circuitry configured to temporarily supply a current through the at least one coil (50) to demagnetize the ferromagnetic cores (46; 47), and electronic circuitry configured to supply a current through the at least one coil (50) for operating the magnetic field sensor(s) in a closed-loop mode.

8. Magnetic transducer, comprising

a magnetic field sensor, and
an electronic circuit comprising
a current source (2) providing a supply current,
a transformer (3) comprising two input terminals and two output terminals,
a fully differential preamplifier (4) comprising two input terminals and two output terminals, the two input terminals coupled to said two output terminals of the transformer (3),
a phase sensitive detector (6) comprising two input terminals coupled to the output terminals of the preamplifier (4) and providing a DC output voltage, and
a logic block (5, 5a) configured to operate the magnetic field sensor to provide an AC output voltage, wherein the magnetic field sensor is a Hall element (1) comprising four terminals serving to receive a supply current and to deliver an output voltage and the logic block (5) comprises circuitry to couple the Hall element (1) to the current source (2) and to the input terminals of the transformer (3) according to a predetermined spinning current scheme, or wherein
the magnetic field sensor is an AMR sensor (19) comprising four terminals serving to receive a supply current and to deliver an output voltage and two terminals serving to receive set and reset current pulses that change the polarity of the output voltage, wherein the terminals serving to receive a supply current are coupled to the current source (2), the terminals serving to deliver an output voltage are coupled to the input terminals of the transformer (3), and the terminals serving to receive set and reset current pulses are coupled to the logic block (5), and the logic block (5) comprises circuitry to deliver set and reset current pulses according to a predetermined frequency, or wherein
the magnetic field sensor is a fluxgate sensor comprising four terminals serving to receive an excitation current and to deliver an output voltage, wherein the terminals serving to receive the excitation current are coupled to the current source (2) and the terminals serving to deliver an output voltage are coupled to the input terminals of the transformer (3), wherein the logic block (5c) comprises circuitry to control the current source (2) to provide the supply current as an AC current having a predetermined frequency.

9. Magnetic transducer, comprising
a first magnetic field sensor and a second magnetic field sensor, and
an electronic circuit comprising
a first current source (2) providing a first supply current,
a second current source (29) providing a second supply current,
a transformer (3), comprising at least one core, two primary windings and at least one secondary winding,
a fully differential preamplifier (4) comprising two input terminals and two output terminals, the two input terminals coupled to two output terminals of the at least one secondary winding of the transformer (3),
a phase sensitive detector (6) comprising two input terminals coupled to the output terminals of the preamplifier (4) and providing a DC output voltage, and
a logic block (5, 5a, 5c) configured to operate the magnetic field sensors to provide an AC output voltage, wherein the first magnetic field sensor and the second magnetic field sensor each is a Hall element (1, 28) comprising four terminals serving to receive a supply current and to deliver an output voltage, and the logic block (5) comprises circuitry to couple the first Hall element (1) to the first current source (2) and to the first primary winding of the transformer (3) according to a predetermined spinning current scheme and to couple the second Hall element (28) to the second current source (29) and to the second primary winding of the transformer (3) according to the predetermined spinning current scheme, or wherein
the first magnetic field sensor and the second magnetic field sensor each is an AMR sensor (19, 31) comprising four terminals serving to receive a supply current and to deliver an output voltage and two terminals serving to receive set and reset current pulses that change the polarity of the output voltage, wherein the terminals serving to receive a supply current of the first AMR sensor (19) are coupled to the first current source (2), the terminals serving to deliver an output voltage of the first AMR sensor (19) are coupled to the first primary winding of the transformer (3), the terminals serving to receive a supply current of the second AMR sensor (31) are coupled to the second current source (29), the terminals serving to deliver an output voltage of the second AMR sensor (31) are coupled to the second primary winding of the transformer (3), and the terminals serving to receive set and reset current pulses of the first and second AMR sensor (19, 31) are coupled to the logic block (5), and the logic block (5) comprises circuitry to deliver set and reset current pulses according to a predetermined frequency, or wherein
the first magnetic field sensor and the second magnetic field sensor each is a fluxgate sensor (32, 33) comprising four terminals serving to receive an excitation current and to deliver an output voltage, wherein the terminals serving to receive the excitation current of the first fluxgate sensor (32) are coupled to the first current source (2) and the terminals serving to deliver an output voltage of the first fluxgate sensor (32) are coupled to the first primary winding of the transformer (3), the terminals serving to receive the excitation current of the second fluxgate sensor (33) are coupled to the second current source (29) and the terminals serving to deliver an output voltage of the second fluxgate sensor (33) are coupled to the second primary winding of the transformer (30), wherein the logic block (5c) comprises circuitry to control the current sources (2, 29) to provide the supply current as an AC current having a predetermined frequency.

10. Magnetic transducer according to claim 8 or 9, wherein the current source(s) (2, 29) is/are configured such that a voltage appearing at the first voltage terminal and a voltage appearing at the second voltage terminal of the respective magnetic field sensor as referenced to ground GND are about equal in size but have opposite signs.

11. System for detecting a leakage current in a machine, the system comprising
at least one first current transducer and at least one second current transducer according to any of claims 1 to 6,
a high voltage DC source (39), having a first voltage terminal to be coupled to a cable (37) and a second voltage terminal to be coupled to ground, and
means for building a difference between an output signal of the first current transducer and an output signal of the second current transducer.

12. Method for measuring a leakage current in a machine (35), the method comprising

A) fitting a head (40) of a first current transducer according to any of claims 1 to 7 around a first cable (37) and fitting a head (41) of a second current transducer according to any of claims 1 to 7 around a second cable (38),
B) coupling a first terminal of a high voltage DC source (39) to the first cable (37) and coupling a second terminal of the high voltage DC source (39) to ground,
C) ramping up the output voltage of the high voltage DC source (39) while maintaining the loading current below a predefined critical value,
D) operating the heads (40, 41) to receive a first output signal responsive to a current flowing through the first cable from the first head (40) and a second output signal responsive to a current flowing through the second cable (38) from the second head (41), and
E) building a difference between the first output signal and the second output signal.

13. Method according to claim 12, further comprising demagnetizing the ferromagnetic cores (46, 47) of the heads (40) and (41) before the step of operating the heads to receive the first and second output signals.

Fig. 1

Fig. 2

Fig. 3

Fig. 4

Fig. 5

Fig. 9

Fig. 6

Fig. 10

Fig. 7

Fig. 11

Fig. 8

**Fig. 12**

**Fig. 13**

Fig. 14

Fig. 15

Fig.16

Fig. 18

Fig. 17

Fig. 19

Fig. 20

Fig. 21

Fig. 22

Fig. 23

26

Fig. 24

Fig. 25A

Fig. 25B

Fig. 26

Fig. 27

Fig. 28

Fig. 29

## EUROPEAN SEARCH REPORT

Application Number

EP 12 17 5456

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2008 224260 A (TAMURA SEISAKUSHO KK) 25 September 2008 (2008-09-25) * abstract; figures 1-8 * ----- | 1 | INV. G01R15/20 |
| X | JP 2001 033491 A (NIPPON SOKEN; TOYOTA MOTOR CORP) 9 February 2001 (2001-02-09) * abstract; figures 1-16 * ----- | 1,11-13 | |
| X | JP 2006 071457 A (DENSO CORP) 16 March 2006 (2006-03-16) * abstract; figures 1-9 * ----- | 2-4, 11-13 | |
| X | US 5 241 263 A (NAOI TOSHIO [JP] ET AL) 31 August 1993 (1993-08-31) * abstract; claims 1-17; figure 11 * * column 2, line 31 - column 3, line 53 * * column 6, line 30 - column 7, line 57 * ----- | 5,11-13 | |
| A | US 5 568 047 A (STAVER DANIEL A [US] ET AL) 22 October 1996 (1996-10-22) * abstract; claims 1-18; figures 1-4 * * column 2, line 15 - line 42 * * column 3, line 1 - column 6, line 37 * ----- | 6-13 | TECHNICAL FIELDS SEARCHED (IPC) G01R |
| A | CYRIUS OUFFOUE ET AL: "Chopper stabilized integrated Hall effect magnetometer", MICROELECTRONICS (ICM), 2009 INTERNATIONAL CONFERENCE ON, IEEE, PISCATAWAY, NJ, USA, 19 December 2009 (2009-12-19), pages 54-57, XP031631833, ISBN: 978-1-4244-5814-1 * abstract; figures 1-7 * * Sections II-IV * ----- -/-- | 6-13 | |

The present search report has been drawn up for all claims

| Place of search | Date of completion of the search | Examiner |
|---|---|---|
| Munich | 15 March 2013 | Nadal, Rafael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 12 17 5456

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2004/124833 A1 (KLIMAN GERALD BURT [US] ET AL) 1 July 2004 (2004-07-01)<br>* abstract; claims 1-21; figures 1-10 *<br>* paragraph [0008] - paragraph [0012] *<br>* paragraph [0024] - paragraph [0043] *<br>----- | 6-13 | |
| A | US 6 617 838 B1 (MIRANDA EVALDO M [US] ET AL) 9 September 2003 (2003-09-09)<br>* abstract; claims 1-11; figures 1-8 *<br>* column 1, line 29 - column 2, line 5 *<br>* column 2, line 33 - column 6, line 11 *<br>----- | 6-13 | |

TECHNICAL FIELDS
SEARCHED      (IPC)

The present search report has been drawn up for all claims

| Place of search | Date of completion of the search | Examiner |
|---|---|---|
| Munich | 15 March 2013 | Nadal, Rafael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...........................................................................................
& : member of the same patent family, corresponding
    document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 12 17 5456

The Search Division considers that the present European patent application does not comply with the
requirements of unity of invention and relates to several inventions or groups of inventions, namely:

1. claims: 1-5

    The subject-matter of claims 1-5 refers to a current
    transducer. The defined current transducer comprises a head
    having a ferromagnetic core, with a particular shape, and an
    air gap in which a magnetic filed sensor is placed.
    ---

2. claims: 6-13

    The subject-matter of claims 6-13 refers to the circuitry,
    the system, and the method for monitoring a magnetic
    transducer. Such a circuitry comprises  a current source, a
    transformer, a fully differential preamplifier, a phase
    sensitive detector, a logic block and a magnetic field
    sensor.
    ---

**ANNEX TO THE EUROPEAN SEARCH REPORT
ON EUROPEAN PATENT APPLICATION NO.**

EP 12 17 5456

This annex lists the patent family members relating to the patent documents cited in  the above-mentioned European search report.
The members are as contained in the European Patent Office EDP file on
The European Patent Office is in no way liable for these particulars which are merely given for the purpose of information.

15-03-2013

| Patent document cited in search report | | Publication date | Patent family member(s) | | Publication date |
|---|---|---|---|---|---|
| JP 2008224260 | A | 25-09-2008 | NONE | | |
| JP 2001033491 | A | 09-02-2001 | NONE | | |
| JP 2006071457 | A | 16-03-2006 | JP | 4321412 B2 | 26-08-2009 |
| | | | JP | 2006071457 A | 16-03-2006 |
| US 5241263 | A | 31-08-1993 | JP | 4252934 A | 08-09-1992 |
| | | | US | 5241263 A | 31-08-1993 |
| US 5568047 | A | 22-10-1996 | DE | 19528501 A1 | 15-02-1996 |
| | | | ES | 2113292 A1 | 16-04-1998 |
| | | | FR | 2723643 A1 | 16-02-1996 |
| | | | JP | 3992760 B2 | 17-10-2007 |
| | | | JP | 8178972 A | 12-07-1996 |
| | | | TW | 462503 U | 01-11-2001 |
| | | | US | 5568047 A | 22-10-1996 |
| US 2004124833 | A1 | 01-07-2004 | NONE | | |
| US 6617838 | B1 | 09-09-2003 | NONE | | |

EPO FORM P0459

For more details about this annex : see Official Journal of the European Patent Office, No. 12/82